Europäisches Patentamt

(19) European Patent Office

Office européen des brevets

(11) Publication number: **0 030 118**
**B1**

(12) **EUROPEAN PATENT SPECIFICATION**

(45) Date of publication of patent specification: **31.10.84**

(21) Application number: **80304234.0**

(22) Date of filing: **26.11.80**

(51) Int. Cl.³: **H 03 K 13/25,** **G 11 C 8/00,**
**G 11 C 11/40**

(54) **A decoder circuit.**

(30) Priority: **29.11.79 JP 154580/79**

(43) Date of publication of application:
**10.06.81 Bulletin 81/23**

(45) Publication of the grant of the patent:
**31.10.84 Bulletin 84/44**

(84) Designated Contracting States:
**DE FR GB NL**

(56) References cited:
**DE-A-2 853 204**
**US-A-4 063 118**

**IEEE INTERNATIONAL SOLID-STATE CIRCUITS
CONF., vol. XXII, 15 February 1979 New York
R.D. PASHLEY et al. "A 16K x 1b Static RAM"
pages 106 to 107**

(73) Proprietor: **FUJITSU LIMITED**
**1015, Kamikodanaka Nakahara-ku
Kawasaki-shi Kanagawa 211 (JP)**

(72) Inventor: **Kurafuji, Setsuo**
**No. 2-5, Edakita 2-chome Midori-ku
Yokohama-shi Kanagawa, 227 (JP)**

(74) Representative: **Bedggood, Guy Stuart et al
Haseltine Lake & Co. Hazlitt House 28
Southampton Buildings Chancery Lane
London WC2A 1AT (GB)**

Courier Press, Leamington Spa, England.

## Description

The present invention relates to a decoder circuit.

A decoder circuit for decoding an address signal to select a memory cell of a memory circuit selects one of a plurality of word lines of the memory circuit and one or two of its bit lines. Such a decoder circuit is usually constituted by NOR gates. It is determined whether a word line is selected or unselected in dependence upon whether or not a decoded output is high-level or low-level. When a low-level output is produced, current flows from the power supply via a NOR gate to the ground side, causing power consumption.

With increased memory circuit capacity the numbers of word lines and bit lines increase and the decoder circuit becomes large scale, to provide for selection between large numbers of word lines and bit lines by means of address signals. In such a case, for example, when one word line is selected leaving the other word lines unselected, a number of decoded outputs are low-level outputs and total power dissipation is so large as not to be negligible. Accordingly, it is necessary to reduce such power dissipation.

For example, a large capacity memory circuit is usually formed by packaging a plurality of memory cards, each memory card comprising a print board (printed circuit board) mounting a plurality of LSI memory chips each of which has memory cells integrated with high density. When accessing the memory circuit, a chip select signal is used for selecting a desired one of the memory chips. It has been proposed to cut power consumption by supplying power (connecting the power source) only to the decoder circuit parts relating to the memory chip selected by the chip select signal.

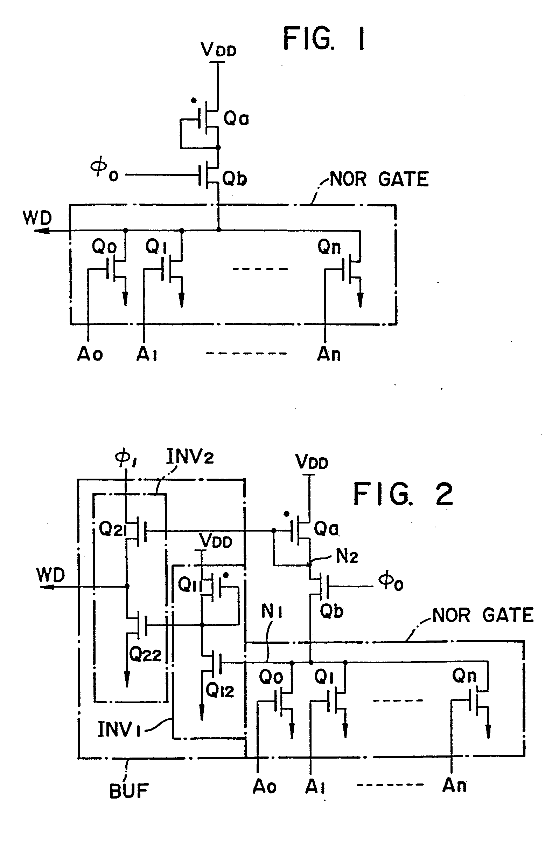

For instance, Figure 1 of the accompanying drawings is a schematic circuit diagram showing principal parts of a conventional decoder circuit, illustrating only those parts relating to one word line. In Figure 1, reference character Qa indicates a depletion type load MOS transistor; Qb designates an enhancement type MOS transistor for power cutting or power dissipation reduction use; Q0 to Qn and Qa identify MOS transistors constituting a NOR gate. The MOS transistors Q0 to Qn have their drains connected together to the source of the transistor Qb and a word line WD and have their sources grounded or connected to a low-potential point and are supplied at their gates with address signals A0 to An, respectively. When a chip select signal $\phi_0$ becomes high-level, the MOS transistor Qb is turned ON and, in this case, if the MOS transistors Q0 to Qn are all in the OFF state, a power supply voltage $V_{DD}$ is applied via the MOS transistors Qa and Qb to the word line WD. In other words, when all bits of the address signals A0 to An are low-level, the word line WD becomes high-level and is selected by the address signal.

When one or more bits of the address signals A0 to An are high-level, the MOS transistors Q0 to Qn corresponding to the high-level bits are turned ON, whereby the word line WD assumes ground potential or the potential of the low-potential point to which the sources of transistors Q0 to Qn are connected; namely, the word line WD becomes low-level and unselected. Assuming, for example, that only the address signal A1 becomes high-level, the MOS transistor Q1 is turned ON and consequently the current from the power supply voltage $V_{DD}$ flows via the MOS transistors Qa, Qb and Q1 to the ground side. In an unselected memory chip, however since the chip select signal $\phi_0$ becomes low-level, the MOS transistor Qb is turned OFF to cut off the current flowing through the NOR gate, thus reducing power dissipation.

With the provision of the MOS transistors Qb which are turned ON and OFF by chip select signals as described above, it is possible to cut power dissipation in unselected memory chips, but this method poses such problems as are mentioned below.

Since a word line WD has connected thereto a number of static memory cells, each formed, for example, by a flip-flop, the stray capacity of the word line WD is relatively large. When the word line WD is selected, it is necessary to charge its stray capacity, so that the rise-up time of the word line WD becomes long. Further, in order that the word line WD once charged may be made unselected, charges stored in the word line WD must be discharged by making any one of the address signals A0 to An high-level to turn ON one or more of the MOS transistors Q0 to Qn forming the NOR gate related to the word line. For rapid charging and discharging of the word line WD, the employment of large capacity MOS transistors as the MOS transistors Qa, Qb and Q0 to Qn has been considered. This, however, leads to problems; for example a large current flows when the word line WD is unselected and the stray capacity of the MOS transistors Q0 to Qn forming the NOR gate becomes large thereby increasing the load capacitance of the address signal lines, with the result that the operating speed of the NOR gate is reduced.

US—A—4 063 118 discloses a dynamic decoder circuit having a logical gate with MOS transistors arranged to receive address signals at their gates and to provide an output dependent upon the values of the address signals. A transistor is connected in series in relation to the logical gate and is arranged to receive a precharging signal P for precharging a capacitor prior to application of address signals. First and second inverters are provided. The second inverter receives the output of the first inverter and a control signal CE. The first inverter receives a signal from a timing pulse generator.

IEEE International Solid-state circuits conference, volume XXII, 15 February 1979, pages 106, 107 discloses a decoder circuit having a logical gate comprising a MOS load transistor and a plurality of MOS transistors arranged to receive address signals at their gates for supplying an output dependent upon the values of the address signals, and a power dissipation reduction transistor connected in series in relation to the logical gate and arranged to receive a control signal for controlling switching ON and OFF thereof. The decoder circuit has first and second inverters comprising MOS transistors, the first arranged to receive the output of the logical gate and the second to receive the output of the first.

According to the present invention there is provided a decoder circuit including:—

a logical gate comprising an MOS load transistor and a plurality of MOS transistors arranged to receive at their gates respective address signals for supplying an output dependent upon the values of the address signals,

an MOS power dissipation reduction transistor connected in series in relation to the logical gate and arranged to receive a first control signal for controlling switching ON and OFF thereof, and

first and second inverters comprising MOS transistors, the first inverter being arranged to receive the output of the logical gate, and the second inverter being arranged to receive the output of the first inverter, characterised in that

the decoder circuit is arranged so that a load transistor of the second inverter receives a second control signal delayed in a phase from the first control signal,

which second control signal is generated from the first control signal in a low impedance drive circuit,

the decoder circuit is arranged so that the said second control signal is received at the drain of the load transistor of the second inverter, the gate of the load transistor of the second inverter being connected to the gate of the load transistor of the logical gate,

and in that the current capacities of transistors constituting the second inverter are larger than the current capacities of the power dissipation reduction transistor and transistors of the logical gate.

Embodiments of the present invention can provide for a cut in decoder circuit power consumption.

Embodiments of the present invention can provide for decoder circuits which ensure rapid rise and fall of word line potential, when selected and then unselected.

Embodiments of the present invention can provide for decoder circuits which ensure prevention of multiple selection of a word line.

Briefly stated, in an embodiment of the present invention, a decoder circuit for decoding an address signal comprises a logical gate which is supplied with a power supply voltage via a power dissipation reduction transistor which is supplied at its gate with a first control signal, a first inverter which is supplied with the output from the logical gate, and a second inverter which is supplied with the output from the first inverter. To a load transistor of the second inverter is applied a second control signal which is delayed in phase relative to the first control signal, and the output from the second inverter is used as a decoded output of the decoder circuit.

Reference is made, by way of example, to the accompanying drawings, in which:—

Figure 1 is a schematic circuit diagram illustrating principal parts of a conventional decoder circuit;

Figure 2 is a schematic circuit diagram illustrating principal parts of an embodiment of the present invention;

Figure 3 is a schematic circuit diagram of a control signal generator circuit for generating a second control signal for the circuit of Figure 2; and

Figure 4 is a waveform diagram explanatory of timings first and second control signals for the circuit of Figure 2.

Figure 2 shows principal parts of an embodiment of the present invention. Parts corresponding to those in Figure 1 are identified by the same reference characters. The parts shown in Figure 2 relate to one word line. In Figure 2, reference character BUF indicates an off buffer circuit composed of first and second inverters INV1 and INV2; Q11 Q12, Q21 and Q22 designate MOS transistors (hereinafter referred to simply as transistors); $\phi_0$ identifies a chip select signal or a first control signal which is derived from the chip select signal; and $\phi_1$ denotes a second control signal which is derived from the first control signal $\phi_0$ and delayed in phase behind it. An output point N1 of the NOR gate transistors Q0 to Qn, which are respectively supplied at their gates with the address signals A0 to An, is connected to the gate of the transistor Q12 of the first inverter INV1, the output from which is provided to the gate of the transistor Q22 of the second inverter INV2, the output from which is applied to the word line WD. To the drain of the load transistor Q21 of the second inverter INV2 the second control signal $\phi_1$ is applied and the gate of the load transistor Q21 is connected to the gate of the load transistor Qa.

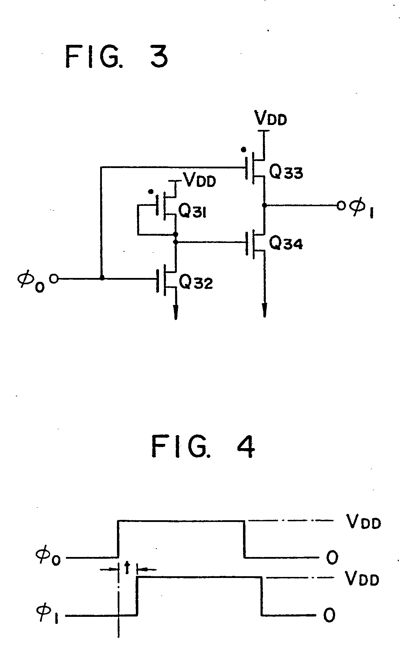

Figure 3 shows an example of a second control signal generator circuit which provides a low impedance drive circuit. In Figure 3, reference characters Q31 and Q33 indicate depletion type transistors; and Q32 and Q34 indicate enhancement type transistors.

Figure 4 is explanatory of the first and second control signals $\phi_0$ and $\phi_1$.

When the first control signal $\phi_0$ is low-level the transistor Q32 is OFF and the transistor Q34 is ON, so that the second control signal $\phi_1$ is

also low-level. When the first control signal $\phi_0$ becomes high-level, the transistor Q32 is turned ON but, due to a lag in the operation of the transistors Q32 and Q34, the switching of the transistor Q34 from the ON state to the OFF state is retarded. Upon turning OFF of the transistor Q34, the second control signal assumes the high level which is equal to the level of the power supply voltage $V_{DD}$. Also, when the first control signal changes from the high level to the low level, the switching of the second control signal from the high level to the low level is retarded. Accordingly, the second control signal $\phi_1$ lags behind the first control signal $\phi_0$ by a time t, as shown in Figure 4.

In Figure 2, when all the bits of the address signals A0 to An become low level and the first control signal $\phi_0$ becomes high, the potential at the output point N1 immediately becomes high-level. This can be understood on the grounds that the word line WD is not directly connected to point N1. As a consequence, the transistors Q12 is turned ON to render the output from the first inverter INV1 low-level. In the second inverter INV2 the transistor Q22 is turned OFF. Since the level at a point N2 in Figure 2 is high, the high-level is applied to the gate of the load transistor Q21 of the second inverter INV2.

The time t after the first control signal becomes high-level, the second control signal becomes high-level and, at this instant, since high-level potential is provided to the gate of the transistor Q21 only in that part of the decoder circuit relating to one selected word line, a current flows from an output terminal (indicated by $\phi_1$) of the low-impedance drive circuit (Figure 3) only to the transistor Q21 of that part of the decoder circuit relating to the selected word line to provide a state which is as if the drain of the transistor Q21 is connected to the power supply $V_{DD}$, and the selected word line WD rapidly becomes high-level. In other words, the word line WD is selected by the address signal.

In this case, since the gate potential of the transistor Q21 and the level of the second control signal $\phi_1$ are equal to the level of the power supply voltage $V_{DD}$, the potential of the word line WD becomes $V_{DD}-V_{th}$, taking into account threshold voltage $V_{th}$ of the transistor Q21. The current capacities of the transistors Q21 and Q22 are selected to be large, whereby it is ensured that even if the stray capacity of the word line WD is relatively large, it is rapidly charged by the high level of the second control signal $\phi_1$, permitting a steep rise of the potential of the word line WD.

When the first control signal $\phi_0$ changes from high level to low level, the second control signal also changes from the high level to the low level to turn OFF the transistor Q12 and to turn ON the transistors Q21 and Q22. As a consequence the word line WD is connected via both the transistors Q21 and Q22 to the low-level and the stored charges in the stray capacity of the word line WD are rapidly discharged, resulting in the potential of the word line WD falling sharply.

Accordingly, the potential of a selected word line rises rapidly and when the selected state changes to the unselected state, the potential of the word line immediately falls, so that the selection of the next word line can be started smoothly, without problems of multiple selection. In this way, the memory accessing operation can be speeded up.

When a memory chip is selected, when the first control signal $\phi_0$ is high-level and any one of bits of the address signals A0 to An is high-level to hold a relevant word line in the unselected state, the potential at the output point N1 of the NOR gate is low-level and the potential at the point N2 is also low-level. Consequently, even if the second control signal $\phi_1$ becomes high-level, the transistor Q21 is turned OFF and the transistor Q22 ON, so that the word line WD is retained low-level. Further, the transistor of the NOR gate corresponding to a high-level bit amongst the bits of the address signals A0 to An is turned N to pass therethrough a current from the power supply voltage $V_{DD}$; however, by providing that the transistors Qa, Qb and Q0 to Qn are small current capacity transistors, power dissipation can be reduced.

If, in the off buffer circuit BUF, the power supply voltage $V_{DD}$ were applied to the drain of the transistor Q21 without using the second control signal $\phi_1$, and the output point N1 of the NOR gate were connected to the gate of the transistor Q21, the potential at the output point N1 of the NOR gate with the transistor Qb ON would become $V_{DD}-V_{th}$ due to the threshold voltage $V_{th}$ of the transistor Qb and this potential would be applied to the gate of the transistor Q21. Assuming that the threshold voltage of the transistor Q21 is also $V_{th}$, a potential, $V_{DD}-2 \cdot V_{th}$, would be provided as high level to the word line WD. That is, as compared with the foregoing embodiment of the present invention, the high level of the word line WD would be relatively low and the charging time of the stray capacity of the word line would become long, resulting in slow rise of the potential of the word line. Moreover, since the stray capacity of the word line WD would be discharged through the transistor Q22 alone, the fall of the potential of the word line WD would also slow down when the word line was changed from the selected state to the unselected state.

In contrast thereto, the described embodiment of the present invention ensures rapid rise and fall of the potential of the word line WD by the use of the first and second control signals $\phi_0$ and $\phi_1$, as described previously.

As has been described in the foregoing, according to the present invention, power consumption in a memory chip unselected state can be reduced by the transistor Qb for power dissipation reduction use and when a memory chip is selected, the potential of a word line selected by an address signal can be made to rise rapidly. Further, when the word line is changed from the selected state to the unselected state, the potential of the word line falls rapidly, so that even if the next word line is immediately selected, there is no fear of multiple selection. In addition, since the transistors constituting the NOR gate, the transistor for power dissipation reduction and the load transistor may be small capacity transistors, the current flowing in the NOR gate when the word line is unselected can be decreased. This also contributes to the reduction of power consumption.

Thus, in a decoder circuit embodying the present invention a transistor for power dissipation reduction use, which is supplied at its gate with a first control signal, is connected in series with a logical gate composed of a load transistor and a plurality of transistors which are supplied at their gates with address signals. There is provided an off buffer circuit which comprises a first inverter for receiving the output from the logical gate and a second inverter for receiving the output from the first inverter. To a load transistor of the second inverter is provided a second control signal delayed in phase behind the first control signal and the output from the off buffer circuit is used as a decoded output of the address signal.

## Claims

1. A decoder circuit including:—
a logical gate comprising an MOS load transistor $(Q_a)$ and a plurality of MOS transistors $(Q_0$ to $Q_n)$ arranged to receive at their gates respective address signals $(A_0$ to $A_n)$ for supplying an output (N1) dependent upon the values of the address signals,
an MOS power dissipation reduction transistor $(Q_b)$ connected in series in relation to the logical gate and arranged to receive a first control signal $(Q_0)$ for controlling switching ON and OFF thereof, and
first and second inverters (INV1, INV2) comprising MOS transistors $(Q_{11}, Q_{12}; Q_{21}, Q_{22})$, the first inverter being arranged to receive the output of the logical gate (N1), and the second inverter being arranged to receive the output of the first inverter, characterised in that
the decoder circuit is arranged so that a load transistor $(Q_{21})$ of the second inverter receives a second control signal $(\phi_1)$ delayed in phase from the first control signal $(\phi_0)$,
which second control signal is generated from the first control signal in a low impedance drive circuit (Fig. 3),
the decoder circuit is arranged so that the said second control signal $(\phi_1)$ is received at the drain of the load transistor of the second inverter (INV2), the gate of the load transistor $(Q21)$ of the second inverter being connected to the gate of the load transistor $(Q_a)$ of the logical gate,
and in that the current capacities of transistors $(Q_{21}, Q_{22})$ constituting the second inverter are larger than the current capacities of the power dissipation reduction transistor $(Q_3)$ and transistors of the logical gate.

2. A decoder circuit as claimed in claim 1, connected with a memory circuit including a plurality of memory chips.

3. A decoder circuit as claimed in claim 2, wherein the first control signal is a chip select signal.

4. A decoder circuit as claimed in claim 3, wherein an output of the second inverter is connected to a word line (WD) of the memory circuit.

## Patentansprüche

1. Dekodierschaltung mit:
einer Logikschaltung, die einen MOS-Last-transistor $(Q_a)$ und eine Anzahl von MOS-Transistoren $(Q_0$ bis $Q_n)$ umfaßt, die so angeordnet sind, daß sie an ihren Gateelktroden entsprechende Adreßsignale $(A_0$ bis $A_n)$ empfangen, um in Abhängigkeit von den Werten der Adreßsignale ein Ausgangssignal (N1) zu liefern.
einem MOS-Transistor $(Q_b)$ zur Reduktion der Verlusleistung, der relativ zu der Logikschaltung in Reihe angeschlossen und so angeordnet ist, daß er ein erstes Steuersignal $(\phi_0)$ zur Steuerung des Ein- und Ausschaltens derselben empfängt,
ersten und zweiten Invertern (INV1, INV2), die MOS-Transistoren $(Q_{11}, Q_{12}; Q_{21}, Q_{22})$ umfassen, von denen der erste Inverter so angeordnet ist, daß er das Ausgangszeichen der Logikschaltung (N1) empfängt und der zweite Inverter so angeordnet ist, daß er das Ausgangszeichen des ersten Inverters empfängt, dadurch gekennzeichnet, daß
die Dekodierschaltung so angeordnet ist, daß ein Lasttransistor (Q21) des zweiten Inverters ein zweites Steuersignal $(\phi_1)$ empfängt, welches in seiner Phase gegenüber dem ersten Steuer-signal $(\phi_1)$ verzögert ist,
das zweite Steuersignal aus dem ersten Steuersignal in einer Treiberschaltung niedriger Impedanz (Fig. 3) erzeugt wird,
die Dekodierschaltung so angeordnet ist, daß das genannte zweite Steuersignal $(\phi_1)$ an der Drainelektrode des Lasttransistors des zweiten inverters (INV2) empfangen wird, die Gateelektrode des Last-transistors $(Q_{21})$ des zweiten Inverters mit der Gateelektrode des Last-transistors $(Q_a)$ der Logikschaltung verbunden ist,
und daß die Stromkapazitäten der Transistoren $(Q_{21}, Q_{22})$, die den zweiten Inverter bilden, größer als die Stromkapazitäten des zur Reduktion der Verlustleistung dienenden Transistors $(Q_b)$ und der Transistoren der Logikschaltung sind.

2. Dekodierschaltung nach Anspruch 1, verbunden mit einer Speicherschaltung, die eine Anzahl von Speicherchips enthält.

3. Dekodierschaltung nach Anspruch 2, bei welcher das erste Steuersignal ein Chipauswalsignal ist.

4. Dekodierschaltung nach Anspruch 3, bei welcher ein Ausgang des zweiten Inverters mit einer Wortleigung (WD) der Speicherschaltung verbunden ist.

**Revendications**

1. Circuit décodeur comportant:
une porte logique comprenant un transistor de charge MOS (Qa) et plusieurs transistors MOS (Q0 à Qn) destinés à recevoir par leurs grilles des signaux d'adresse respectifs (A0 à An) afin de délivrer un signal de sortie (N1) qui dépend des valeurs des signaux d'adresse,
un transistor MOS de réduction de la dissipation d'énergie électrique (Qb) connecté en série avec la porte logique et conçue pour recevoir un premier signal de commande (φ0) afin de commander sa commutation à l'état conducteur et à l'état non conducteur, et
un premier et un deuxième inverseur (INV1, INV2) comprenant des transistors MOS (Q11, Q12; Q21, Q22), le premier inverseur étant destiné à recevoir le signal de sortie de la porte logique (N1) et le deuxième inverseur étant, destiné à recevoir le signal de sortie du premier inverseur, caractérisé en ce que:

le ciruict décodeur est conçu de façon qu'un transistor de charge (Q21) du deuxième inverseur reçoive un deuxième signal de commande (φ1) retardé en phase par rapport au premier signal de commande (φ0),
lequel deuxième signal de commande est produit à partir dur premier signal de commande dans un circuit de commande à faible impédance (figure 3),
le circuit décodeur est conçu de façon que le deuxième signal de commande (φ1) soit reçu au niveau du drain du transistors de charge du deuxième inverseur (INV2), la grille du transistor de charge (Q21) du deuxième inverseur étant connecté à la grille du transistor de charge (Qa) de la porte logique,
et en ce que les capacités de courant des transistors (Q21, Q22) constituant le deuxième inverseur sont plus grandes que les capacités de courant du transistor (Qb) de réduction de la dissipation d'énergie électrique et des transistors de la porte logique.

2. Circuit décodeur selon la revendication 1, connecté à un circuit de mémoire comportant plusieurs puces de mémoire.

3. Circuit décodeur selon la revendication 2, où le premier signal de commande est un signal de sélection de puce.

4. Circuit décodeur selon la revendication 3, où une sortie du deuxième inverseur est connectée à une ligne de mot (WD) du circuit de mémoire.

# FIG. 1

$V_{DD}$

Qa

$\phi_0$ ——| Qb

NOR GATE

WD ←

$Q_0$  $Q_1$  — — — — —  $Qn$

$A_0$  $A_1$  — — — — — — — —  $An$

# FIG. 2

$\phi_1$  INV2

$V_{DD}$

$Q_{21}$

$V_{DD}$

Qa

N2

WD ←

$Q_1$

$\phi_0$

Qb

$Q_{22}$

N1

NOR GATE

$Q_{12}$

$Q_0$  $Q_1$  — — — — —  $Qn$

INV1

BUF

$A_0$  $A_1$  — — — — — — —  $An$

# FIG. 3

# FIG. 4